# EUROPEAN PATENT SPECIFICATION

(11) **EP 1 170 798 B1**
(45) Date of publication and mention of the grant of the patent: **06.09.2006**
(21) Application number: 00204838.7
(22) Date of filing: 14.12.2000
(51) Int. Cl.: H01L 27/115, G11C 16/04, G11C 16/08, G11C 8/00

(54) **Non-volatile memory matrix architecture**
Architektur eines Festwertspeicherfelds
Architecture de matrice de mémoire non-volatile

(30) Priority: 04.07.2000 EP 00830468
(43) Date of publication of application: 09.01.2002
(73) Proprietor: STMicroelectronics S.r.l., 20041 Agrate Brianza (Milano) (IT)
(72) Inventor: Rolandi, Paolo, 27058 Voghera (Pavia) (IT)
(74) Representative: Botti, Mario

(56) References cited:
- EP-A- 0 552 531
- EP-A- 0 854 514
- WO-A-96/08840
- US-A- 5 200 350
- US-A- 6 040 234

## Description

### Field of the invention

The present invention relates to a non-volatile memory matrix, particularly of the EPROM type.

Specifically the invention relates to non-volatile memory matrix architecture having a virtual ground monolithically integrated on semiconductor, and of the type comprising a plurality of memory cells organized into matrix blocks or sectors, which are placed on rows and columns and associated with respective row and column decoding circuits.

Particularly, but not exclusively, the invention relates to a memory matrix having a small number of contacts and the following description is made referring to this application field, with the only aim to simplify its exposition.

### Prior Art

As it is well known, EPROM or Flash EPROM electronic memory devices integrated on semiconductor comprise a plurality of non-volatile memory cells organized into matrices; that is the cells are organized into rows, called word lines, and columns, called bit lines.

Each non-volatile memory cell comprises a MOS transistor, in which the gate electrode, placed over the channel region, is floating, that is such gate electrode has a high D.C. impedance towards all the other terminals of the same cell and of the circuit in which the cell is inserted.

The cell also comprises a second electrode, called control gate electrode, which is driven by suitable driving voltages. The other transistor electrodes are the usual drain and source terminals.

The most recent developments in the field of non-volatile memories, particularly EPROM and FLASH memories, are directed to the increase of the memorizing capacity, due to process architectures and/or innovative designs. In some cases old ideas, abandoned in the past because of technologic "immaturity", are re-proposed.

A first known solution used to increase the memory capacity of a memory matrix provides with the employment of the so called multilevel cells, which can memorize several memory stages.

Although this first solution is advantageous from different points of view, it has some drawbacks, in fact the multilevel technique is quite elaborated and requires a particular architecture.

A second known solution is to use memory matrices having an architecture of the virtual ground type, that is matrices of the contactless type. In this type of matrix technology the field oxide layer is not present in the matrix active area, where the memory cells are formed.

An example of this type of matrices is described in the U.S. patent No. 5,204,835.

Although achieving its objective, not even this solution is devoid of drawbacks. In fact, it is necessary to introduce some selection transistors, in order to correctly read cell groups belonging to the same row.

Such transistors occupy a relevant portion of the available area on the integrated circuit.

Another example this type of matrices is described in the European Paten Application No. 552 531.

In particular, in this document each memory block comprises two transistors sharing a single conduction region, and each column of the block is connected with a respective select transistor.

A non-volatile semiconductor memory with a high integration is known from the US Patent No. 6,040,234.

The technical problem at the basis of the present invention is to form a non-volatile memory matrix architecture for electronic memory devices integrated on semiconductor and, particularly, a virtual ground matrix, having structural and functional features which allow to reach a very high density and circuital dimensions smaller than the ones of the devices formed according to the prior art.

### Summary of the invention

The resolutive idea at the basis of the present invention is to eliminate memory cell selection transistors and to obtain an insulation among the matrix column blocks, due to some insulation stripes, which allow to use traditional methods for the row and column decoding.

On the basis of such resolutive idea, the technical problem is solved by a non-volatile memory matrix architecture of the type above indicated and defined in the characterizing part of claim 1.

The features and the advantages of the device according to the invention will be apparent in the following description, of an embodiment thereof, given by way of non-limitative example with reference to the accompanying drawings.

### Brief description of the drawings

In such drawings:
- figure 1 shows an electric diagram of a memory matrix block, forming an EPROM or a FLASH-EPROM device according to the invention;
- figure 2 shows an electric diagram of a particular located between two memory matrix blocks according to the invention;
- figure 3 shows a schematic view of a decoding circuitry, which is associated with the matrix of figure 1;
- figure 4 shows a diagram as a function of the time of an ATD signal, which is present in the matrix of figure 1;
- figure 5 shows a particular of the decoding circuitry of figure 3;
- figure 6 shows a possible layout of a matrix memory cell according to the invention.

### Detailed Description

With reference to the above figures, a non-volatile memory matrix portion formed according to the invention is totally and schematically indicated at 1.

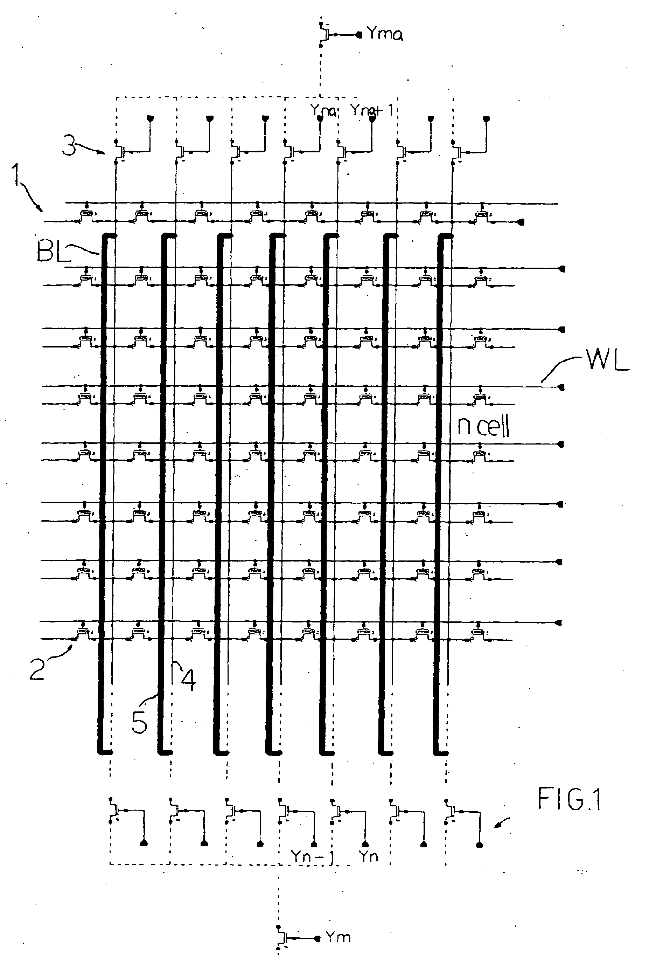

The memory portion 1 of figure 1 is substantially a block or a sector of memory cells 2, organized into columns, which are called bit line BL, and into rows, called word line WL, according to a traditional structure, so that the cells are selected by standard decoding circuits.

A plurality of cells 2 and plural decoding devices 3 are present in block 1. In detail, floating gate MOS devices, which form single memory cells 2, and MOS devices 3, which perform the decoding function of the single cells 2, are provided.

An architecture of the NOR type is proposed; such architecture has a matrix area smaller than the one obtained with an architecture equal to NAND.

In particular, every single non-volatile memory cell 2 comprises a MOS transistor, in which a gate region placed over the channel region is floating, that is such gate region presents a high D.C. impedance towards all the other terminals of the same cell and of the circuit in which the cell is inserted.

The cell also comprises a second region, called control gate region, which is driven by suitable driving voltages. The other transistor electrodes are the usual drain and source terminals.

According to a known art, the floating gate and control gate regions are formed with respective polysilicon layers, which are insulated one from the other by a dielectric layer.

The control gate regions of cells belonging to the same row, are connected with each other through a conduction word line WL.

The adjacent cells 2, belonging to the same row, share the same source or drain region 4.

Such source and drain regions 4 of the cells are formed by means of some diffusions in active area and are alternatively used as source and drain regions, as it is hereafter described.

Furthermore, the source and drain regions 4 are in contact with a metal line 5, which forms the bit line BL, for examples every 16 word lines.

In figure 6 a possible layout of a memory cell 2 is shown. Particularly, on a substrate 2a, for example of the P- type, source and drain regions 4 are formed through, for example, an N+ type implantation into the substrate 2.

In figure 6 the control gate region is also shown; such region is formed by a polysilicon stripe, which is also used to form the word lines.

As it is shown in figure 1, the decoding MOS devices 3 comprise a Yn transistor connected with each matrix column. Such Yn transistors are therefore connected with a Ym pass transistor depending on the number of the matrix outputs.

Also a second Yna transistor is connected with each matrix column. Such Yna transistors are therefore connected with a second Yma pass transistor.

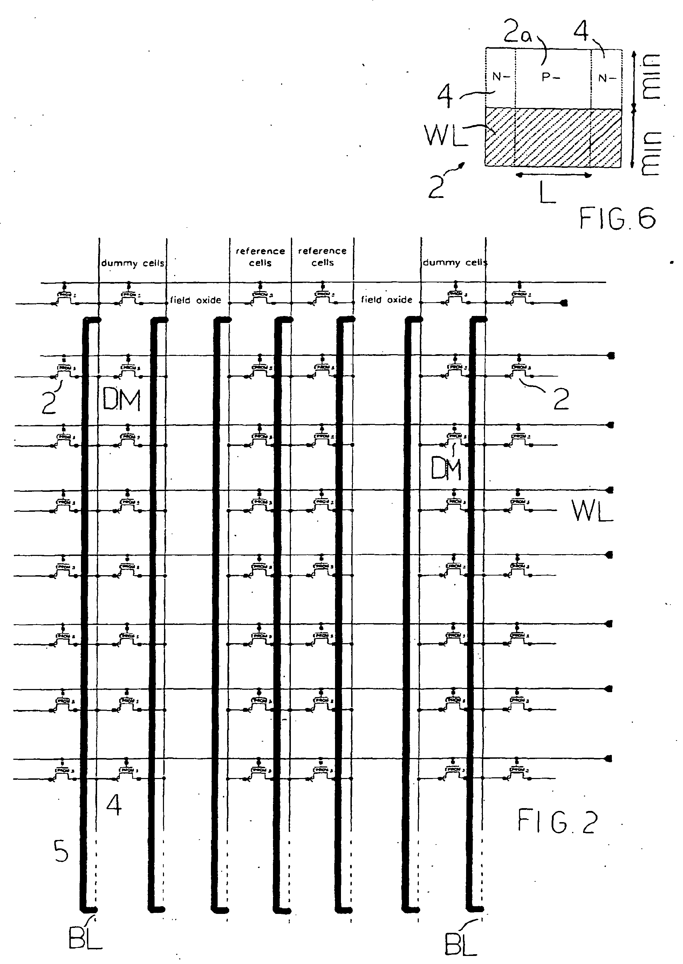

According to the invention, the complete memory matrix provides with a plurality of blocks 1. Such blocks 1 are divided by at least an insulation layer 7, as shown in figure 2.

Advantageously, this insulation layer 7 is a field oxide layer, which is formed between a block and the adjacent one. In such a way cells belonging to adjacent blocks are avoided to be in series. In this embodiment, it is possible to avoid to introduce selection transistors, which would be otherwise necessary to univocally identify a memory cell.

Advantageously, in figure 2 a preferred embodiment is shown. In fact, between the two memory cell blocks two insulation stripes 7 are arranged, and referring cells 8 are inserted between the two stripes 7.

Advantageously, the memory blocks 1 are delimited by non-used cell columns, called DUMMY columns.

The method used to select a memory cell 2 is hereafter described according to the invention.

Particularly, the selection of this nth cell 2 is obtained by simultaneously connecting the nth bit-line to the circuitry 3 of the column decoding, and therefore to the reading circuitry, as it happens in the prior art and by short-circuiting the ground 1-nth bit line.

In such a way, the bit line n becomes the drain region of the selected cell 2, while the bit line n- 1 becomes the source region of the same cell.

As it has been said, the word lines WL are formed in polysilicon and are horizontally placed at a distance equal to the lithographic minimum, with a length equal to the lithographic minimum (min), as shown in figure 6. In such figure, L also indicates the length of the cell 2.

The bit lines BL, which are formed through the metal line 5, are vertically placed and are in contact with the active area, which is below each n lines, for example 16 word lines. Also the below active area is vertically placed, without solution of continuity, the whole array long, and forms the cell source or drain regions, depending on the bias voltages.

Advantageously, the bit line BL has been made out of metal and operates as a conductive shunt of the active area layer, therefore improving the resistivety of such layer. The vertical stripes of active area have dimensions equal to the lithographic minimum and a distance determined by the desired features of the non-volatile memory cell; such stripes operate as source or drain of the selected cells.

The matrix decoding method is hereafter described according to the invention.

The nth cell indicated in figure 1 should be considered as an example. Such cell comprises a drain, constituted by the Yn bit line, and of a source, constituted by the Yn- 1 bit line.

The cell selection is made when for example two decoding levels are used, by enabling a Ym pass transistor of the Yn bit line through the traditional decoding with the Yn signal and by short-circuiting the Yn- 1 bit line through another Yna transistor, which is connected to the second Yma pass transistor, the latter in its turn ground connected.

Such Yna transistors and the second Yma pass transistor are placed in the bit line area opposite to the column decoding, with the gate region connected to the Yn signal, which is the same signal used in the column decoder. Thus, by partially repeating the column decoding, the simultaneous selection of the drains and the connection to ground of the cell source are obtained.

According to the invention, a particular row decoding circuitry 10 has been advantageously provided. Such circuitry will be hereafter described, making reference to a more general decoding case presenting three levels.

In order to improve the understanding of the peculiarities of this innovative decoding circuitry, it is worth to remember that the technologies in the non-volatile EPROM, ROM and FLASH memory sector employ lithographs at 0.18um and the row and/or column decoding circuit planning becomes more and more complex because the difference of the area amount between the memory cells and the peripheral transistors is greater and greater.

In order to effectively use so high lithographic resolutions, without resorting additional metallization layers or an exceeding area increase of the decoders, it has been thought a row decoding architecture with N-Channel transistors, which have the only role of pass-transistors.

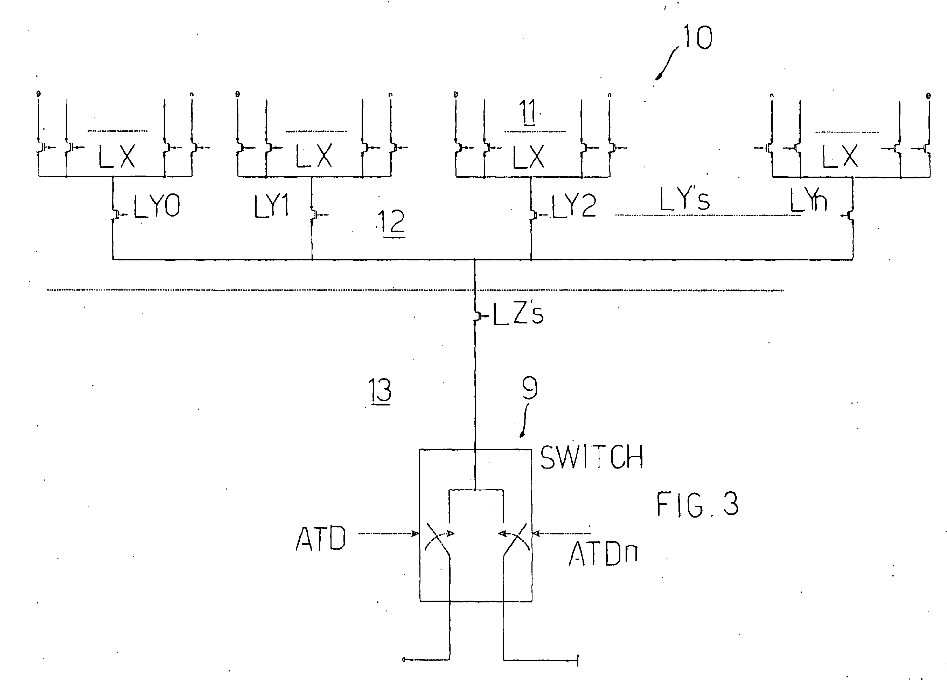

As an example it should be observed the structure of figure 3, where three decoding levels 11, 12 and 13 are shown. There is obviously the possibility to provide a higher or a lower number of levels, which substantially depend on the number of rows to select.

It is further provided a switch 9, which is associated with the decoding circuitry 10. The switch 9 is driven by the well known ATD (Address Transition Detection) signal, which is always present in a non-volatile memory, and by the complement ATDn signal.

The decoding circuitry 10 comprises N-Channel transistors driven on each level by respective Lx, Ly, Lz decoding signals, which have to be suitably boosted as regards to the Vdd supply, during the reading operation, so that the transfer of the total supply to the selected row is allowed.

The proposed decoding can be formed with only a metallization level and can be particularly used in submicrometric technologies.

Every time that a commutation in the access addresses to the memory occurs, an ATD pulse is generated; such ATD pulse is normally used also to synchronize many operations inside the memory device. According to the invention, the ATD signal is also applied to the switch 9, in order to have this switch 9 turning on towards the ground.

In such a way, during the duration of the ATD pulse, the ground potential is applied on all the word lines, by means of a abilitation of the respective decoding levels 11, 12, 13 through the Lx, Ly, Lz signals. The ATDn complement signal forces indeed the switch 9 to the switching, towards the Vdd supply.

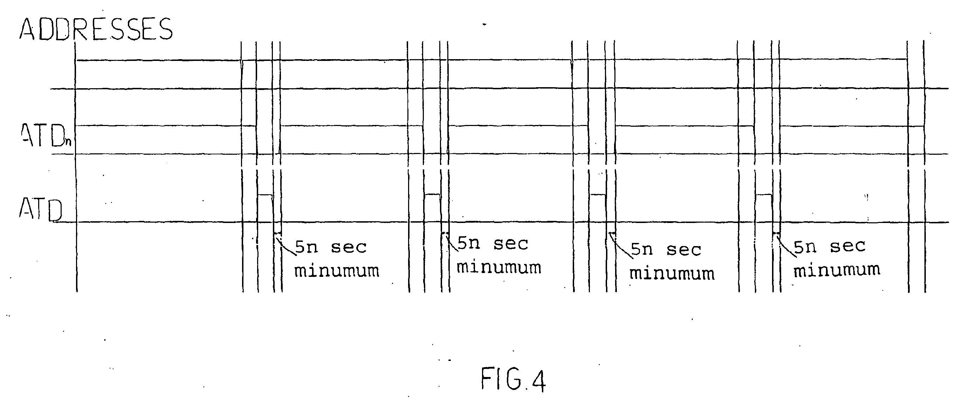

The switching time duration is schematically shown in figure 4.

In these operative conditions the supply potential is therefore applied to the word line, by means of a abilitation of the respective decoding levels 11, 12, 13, and through the Lx, Ly, Lz signals.

The supply of the Lx, Ly, Lz signals is guaranteed by a charge pump, not shown since it is conventional, which allows a total driving of the pass-transistors to the considered Vdd voltage.

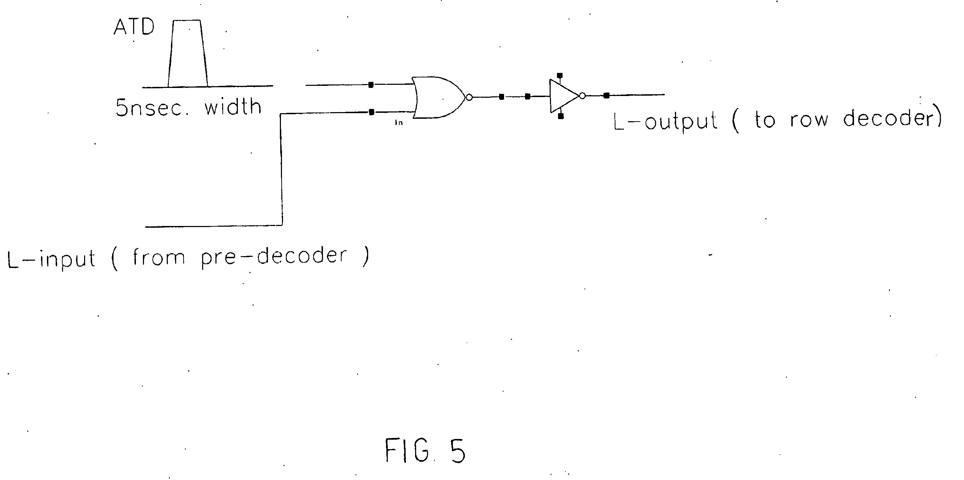

Each of the decoding signals of the "L" type is obtained by the series of a pair of logic gates. As an example in figure 5 it is shown a possible circuital structure comprising a gate NOR 14 having two inputs and to which an inverter 15 is cascade connected.

A first input of the gate NOR 14 receives the ATD signal, while the other input receives an L signal from a pre-decoder, which is not shown since it is conventional.

The output of this series of logic gates 14, 15 is applied to a respective transistor of the row decoding.

In the end, the memory matrix according to the invention allows to form a very compact matrix, avoiding the use of the selection transistors and introducing some insulation stripes between the blocks, with a great reduction of the total space.

The selection of the single memory cells occurs in a simple and effective way, thanks to a pass-transistor decoding circuitry.

In the end, the architecture according to the invention leads to a considerable efficiency gain of the memory cells, since the metal line 5 contacts the source and drain regions every 16 word lines. In the prior art the selection transistors are indeed placed every 64 word lines, with a clear decay of the memory cells performances.

The performances improve also thanks to the features of the source and drain regions of the cell being interchangeable with each other.

Furthermore, the source and drain region resistance of the memory cell is advantageously the same.

## Claims

1. Non-volatile memory matrix architecture of the NOR type with virtual ground monolithically integrated on semiconductor, and of the comprising a plurality of memory cells (2), each cell having respective source and drain regions (4), which cells are organized into blocks or sectors placed on rows (WL) and columns (BL) with associated row and column decoding circuits, where said blocks or sectors are separated from each other by at least an insulation strip (7), which is parallel to the columns (BL) **characterized in that** each block or sector comprises a plurality of adjacent cell pairs, belonging to the same row, adjacent cells sharing a respective source or drain region (4), said respective source and drain regions being interchangeable.

2. Non-volatile memory matrix architecture according to claim 1, **characterized in that** said blocks or sectors are separated by two insulation stripes (7) in reciprocal spaced relation.

3. Non-volatile memory matrix architecture according to claim 2, **characterized in that** it comprises referring cells (8), formed between the two insulation stripes (7).

4. Non-volatile memory matrix architecture according to any of the previous claims, **characterized in that** said insulation stripes (7) are made of silicon oxide.

5. Non-volatile memory matrix architecture according to claim 1, **characterized in that** it comprises a pass-transistor row decoding circuitry (10), having a number of levels depending on the number of rows to select.

6. Non-volatile memory matrix architecture according to claim 5, **characterized in that** a selecting switch (9) driven by an ATD signal is connected to said decoding circuitry (10).

7. Non-volatile memory matrix architecture according to claim 5, **characterized in that** said pass-transistors are N-Channel and are driven on each level by respective (Lx, Ly, Lz) signals.

8. Non-volatile memory matrix architecture according to claim 7, **characterized in that** said signals are obtained by a logic gate (14, 15) cascade driven by an ATE signal .

9. Non-volatile memory matrix architecture according to claim 1, **characterized in that** each column (BL) of the matrix is coupled to a selection (Ym) pass-transistor, and **in that** the columns of a block or sector are coupled to a pass-transistor (Ym) of a block selection.

10. Non-volatile memory matrix architecture according to claim 1, **characterized in that** said matrix columns comprise a conductive stripe (5), which is in contact with said source or drain regions (4) every 16 rows.

11. Method to select a non-volatile memory cell (2), comprised in a non-volatile memory matrix architecture of NOR type with virtual ground monolithically integrated on semiconductor, said matrix comprising a plurality of transistor cells (2), with respective source and drain regions, which are organized on rows or word lines (WL), and columns or bit lines (BL) of matrix blocks or sectors, with associated row and column decoding circuits, **characterized in that** each block or sector comprises a plurality of adjacent cell pairs, belonging to the same row, adjacent cells sharing a respective source or drain region, the selection of each of said cell (2) being obtained by connecting the respective bit lines to corresponding column decoding circuits (3), and simultaneously connecting an adjacent bit line to a reference potential, in such a way that said respective bit line becomes the drain region of the selected cell (2), while the adjacent bit line becomes the source region of the same cell.

## Patentansprüche

1. Architektur einer nicht flüchtigen Speichermatrix der NOR-Art mit virtueller Erde, die auf einem Halbleiter monolithisch integriert ist und von der Art ist, die eine Vielzahl von Speicherzellen (2) umfasst, wobei jede Zelle entsprechende Source- und Drain-Bereiche (4) aufweist und die Zellen in Blöcke oder Sektoren organisiert sind, die in Reihen (WL) und Spalten (BL) mit assoziierten reihen- und spaltendekodierenden Schaltungen organisiert sind, wobei die Blöcke oder Sektoren voneinander durch mindestens einen isolierenden Streifen (7) beabstandet sind, welcher parallel zu den Reihen (BL) verläuft, **dadurch gekennzeichnet, dass** jeder Block oder Sektor eine Vielzahl von benachbarten Zellenpaaren umfasst, die zur selben Reihe gehören, wobei benachbarte Zellen sich einen entsprechenden Source- oder Drainbereich (4) teilen und entsprechende Source- und Drain-Bereiche untereinander austauschbar sind.

2. Architektur einer nicht flüchtigen Speichermatrix nach Anspruch 1, **dadurch gekennzeichnet, dass** die Blöcke oder Sektoren durch zwei Isolierungsstreifen (7) in reziprok beabstandeter Beziehung getrennt sind.

3. Architektur einer nicht flüchtigen Speichermatrix nach Anspruch 2, **dadurch gekennzeichnet, dass** sie Referenzzellen (8) umfasst, die zwischen zwei Isolierungsstreifen (7) ausgebildet sind.

4. Architektur einer nicht flüchtigen Speichermatrix nach einem der vorhergehenden Ansprüche, **dadurch gekennzeichnet, dass** die Isolierungsstreifen (7) aus Siliziumoxid hergestellt sind.

5. Architektur einer nicht flüchtigen Speichermatrix nach Anspruch 1, **dadurch gekennzeichnet, dass** sie eine Durchleitungstransistorreihendekodierschaltung (10) mit einer Anzahl von Ebenen in Abhängigkeit von der Zahl der auszuwählenden Reihen umfasst.

6. Architektur einer nicht flüchtigen Speichermatrix nach Anspruch 5, **dadurch gekennzeichnet, dass** ein Auswahlschalter (9) mit der Dekodierschaltung (10) verbunden ist, der von einem ATD-Signal getrieben wird.

7. Architektur einer nicht flüchtigen Speichermatrix nach Anspruch 5, **dadurch gekennzeichnet, dass** die Durchleitungstransistoren vom N-Kanaltyp sind und auf jeder Ebene durch entsprechende (Lx, Ly, Lz) Signale getrieben werden.

8. Architektur einer nicht flüchtigen Speichermatrix nach Anspruch 7, **dadurch gekennzeichnet, dass** die Signale von einer Kaskade eines logischen Gatters (14, 15) erhalten werden, die von einem ATD-Signal getrieben wird.

9. Architektur einer nicht flüchtigen Speichermatrix nach Anspruch 1, **dadurch gekennzeichnet, dass** jede Spalte (BL) der Matrix mit einem Durchleitungstransistor zur Auswahl (Ym) gekoppelt ist und dass die Reihen eines Blocks oder eines Sektors mit einem Durchleitungstransistor (Ym) einer Blockauswahl gekoppelt sind.

10. Architektur einer nicht flüchtigen Speichermatrix nach Anspruch 1, **dadurch gekennzeichnet, dass** die Matrixspalten einen leitenden Streifen (5) umfassen, der in Kontakt mit den Source- oder Drain-Bereichen (4) aller 16 Reihen steht.

11. Verfahren zur Auswahl einer nicht flüchtigen Speicherzelle (2), die in einer Architektur einer nicht flüchtigen Speichermatrix vom NOR-Typ mit virtueller Erde umfasst ist, die monolithisch in einem Halbleiter integriert ist, wobei die Matrix eine Vielzahl von Transistorzellen (2) mit entsprechenden Source- und Drain-Bereichen umfasst, die in Reihen oder Wortlinien (WL) und Spalten oder Bit-Linien (BL) von Matrixblöcken oder Sektoren mit assoziierten reihen- und spaltendekodierenden Schaltungen organisiert sind, **dadurch gekennzeichnet, dass** jeder Block oder jede Spalte eine Vielzahl von benachbarten Zellenpaaren umfasst, die einer selben Reihe angehören, wobei benachbarte Zellen sich einen entsprechenden Source- oder Drain-Bereich teilen, wobei die Auswahl jeder Zelle (2) durch Verbinden der entsprechenden Bit-Linien mit entsprechenden spaltendekodierenden Schaltungen (3) und gleichzeitigem Verbinden einer benachbarten Bit-Linie mit einem Referenzpotential erfolgt, so dass die entsprechende Bit-Linie zum Drain-Bereich der ausgewählten Zelle (2) wird, während die benachbarte Bit-Linie zum Source-Bereich der selben Zelle wird.

## Revendications

1. Architecture de matrice de mémoire non volatile du type NON OU avec masse virtuelle intégrée monolithiquement sur semi-conducteur, et du type comprenant une pluralité de cellules de mémoire (2), chaque cellule comportant des régions de source et de drain (4) respectives, lesquelles cellules sont organisées en blocs ou secteurs placés sur des rangées (WL) et des colonnes (BL), avec des circuits de décodage de rangée et de colonne associés, dans laquelle lesdits blocs ou secteurs sont séparés les uns des autres par au moins une bande d'isolement (7), qui est parallèle aux colonnes (BL), **caractérisée en ce que** chaque bloc ou secteur comprend une pluralité de paires de cellules adjacentes appartenant à la même rangée, des cellules adjacentes partageant une région de source ou de drain (4) respective, lesdites régions de source et de drain respectives étant interchangeables.

2. Architecture de matrice de mémoire non volatile selon la revendication 1, **caractérisée en ce que** lesdits blocs ou secteurs sont séparés par deux bandes d'isolement (7) dans une relation d'espacement réciproque.

3. Architecture de matrice de mémoire non volatile selon la revendication 2, **caractérisée en ce qu'**elle comprend des cellules référantes (8), formées entre les deux bandes d'isolement (7).

4. Architecture de matrice de mémoire non volatile selon l'une quelconque des revendications précédentes, **caractérisée en ce que** lesdites bandes d'isolement (7) sont réalisées en oxyde de silicium.

5. Architecture de matrice de mémoire non volatile selon la revendication 1, **caractérisée en ce qu'**elle comprend des éléments de circuit de décodage de rangée de transistor de passage (10), dont le nombre de niveaux est fonction du nombre de rangées à sélectionner.

6. Architecture de matrice de mémoire non volatile selon la revendication 5, **caractérisée en ce qu'**un commutateur de sélection (9) commandé par un signal ATD est connecté auxdits éléments de circuit de décodage (10).

7. Architecture de matrice de mémoire non volatile selon la revendication 5, **caractérisée en ce que** lesdits transistors de passage sont à canal N et sont commandés sur chaque niveau par des signaux (Lx, Ly, Lz) respectifs.

8. Architecture de matrice de mémoire non volatile selon la revendication 7, **caractérisée en ce que** lesdits signaux sont obtenus par une porte logique (14, 15) commandée en cascade par un signal ATD.

9. Architecture de matrice de mémoire non volatile selon la revendication 1, **caractérisée en ce que** chaque colonne (BL) de la matrice est couplée à un transistor de passage (Ym) de sélection, et **en ce que** les colonnes d'un bloc ou secteur sont couplées à un transistor de passage (Ym) d'une sélection de bloc.

10. Architecture de matrice de mémoire non volatile selon la revendication 1, **caractérisée en ce que** lesdites colonnes de matrice comprennent une bande conductrice (5), qui est en contact avec lesdites régions de source ou de drain (4) toutes les 16 rangées.

11. Procédé pour sélectionner une cellule de mémoire non volatile (2), comprise dans une architecture de matrice de mémoire non volatile du type NON OU avec masse virtuelle intégrée monolithiquement sur semi-conducteur, ladite matrice comprenant une pluralité de cellules de transistor (2), avec des régions de source et de drain respectives, qui sont organisées sur des rangées ou des lignes de mot (WL), et des colonnes ou des lignes de bit (BL) de blocs ou secteurs de matrice, avec des circuits de décodage de rangée et de colonne associés, **caractérisé en ce que** chaque bloc ou secteur comprend une pluralité de paires de cellules adjacentes appartenant à la même rangée, des cellules adjacentes partageant une région de source ou de drain respective, la sélection de chacune desdites cellules (2) étant obtenue en connectant les lignes de bit respectives à des circuits de décodage de colonne (3) correspondants, et en connectant simultanément une ligne de bit adjacente à un potentiel de référence, de manière à ce que ladite ligne de bit respective devienne la région de drain de la cellule (2) sélectionnée, tandis que la ligne de bit adjacente devient la région de source de la susdite cellule.
